# FASCICULE DE BREVET EUROPEEN

(11) **EP 3 427 298 B1**
(45) Date de publication et mention de la délivrance du brevet: **03.04.2024**
(21) Numéro de dépôt: 17709701.1
(22) Date de dépôt: 10.03.2017
(51) Int. Cl.: G02B 27/01, H01L 25/075, H01L 33/08, H01L 33/18, H01L 33/24, H01L 33/50

(54) **AFFICHEUR TÊTE HAUTE COMPRENANT UN ÉCRAN ÉMISSIF À DELS**
HEAD-UP-ANZEIGE MIT EINEM LED-EMISSIONSBILDSCHIRM
HEAD-UP DISPLAY COMPRISING AN LED-BASED EMISSIVE DISPLAY

(30) Priorité: 11.03.2016 FR 1600410
(43) Date de publication de la demande: 16.01.2019
(73) Titulaire: Valeo Comfort and Driving Assistance, 94000 Créteil (FR)
(72) Inventeur: GRANDCLERC, François, 94046 Créteil Cedex (FR); MERMILLOD, Pierre, 94046 Créteil Cedex (FR)
(86) Numéro de dépôt international: PCT/EP2017/055753
(87) Numéro de publication internationale: WO 2017/153600

(56) Documents cités:
- EP-A2- 2 665 100
- WO-A1-2008/129859
- FR-A1- 3 019 380
- US-A1- 2011 254 034
- US-A1- 2014 063 359
- US-A1- 2014 124 802
- US-A1- 2016 025 973
- US-A1- 2016 025 976
- US-B1- 7 332 746

## Description

### DOMAINE TECHNIQUE AUQUEL SE RAPPORTE L'INVENTION

La présente invention concerne de manière générale le domaine des afficheurs tête haute.

Elle concerne plus particulièrement un afficheur tête haute comprenant, en tant que dispositif de génération d'images, un écran comprenant une matrice de modules formant chacun un pixel, et une matrice d'éléments de commande destinés à adresser respectivement chacun de ces modules.

### ARRIERE-PLAN TECHNOLOGIQUE

Le principe des afficheurs tête haute pour véhicule est de projeter des images, notamment utiles à la conduite, directement dans le champ de vision d'un conducteur.

De tels afficheurs tête haute comprennent un dispositif de génération d'images adapté à générer des images vers un dispositif de projection d'images qui les transmet en direction d'un combineur ou d'un parebrise placé dans le champ de vision d'un conducteur.

On connaît des dispositifs de génération d'images comprenant un écran formé de pixels rétroéclairés par des sources lumineuses pour former une image en direction du dispositif de projection. En général, dans ces dispositifs de génération d'images, un réflecteur et un diffuseur sont prévus pour maximiser et homogénéiser la lumière reçue par l'écran.

On connaît également des dispositifs de génération d'images comprenant un diffuseur dont une face d'entrée est balayée par un faisceau lumineux pour former une image en sortie dudit diffuseur. Le faisceau lumineux balayant la face d'entrée du diffuseur est, dans ce cas, généré par une unité de balayage.

L'écran et le diffuseur sont des éléments passifs nécessitant un rétroéclairage. L'efficacité optique de ces dispositifs de génération d'images est médiocre puisqu'une grande partie des faisceaux lumineux générés en vue du rétroéclairage est perdue, et qu'à ce jour cette perte est principalement compensée en augmentant la puissance des faisceaux lumineux générés.

En outre, les unités de rétroéclairage ou de balayage sont volumineuses et participent à l'encombrement de l'afficheur tête haute dans le véhicule.

On connaît également, notamment du document US 2014/063359 A1 un afficheur tête haute dont l'écran est formé d'une matrice de diodes électroluminescentes pour lequel la luminosité n'est pas toujours suffisante pour chaque pixel.

### OBJET DE L'INVENTION

Afin de remédier aux inconvénients précités de l'état de la technique, la présente invention propose un afficheur tête haute amélioré, conformément à la revendication 1 en annexe. Des modes de réalisation avantageux de la présente invention sont l'objet des revendications dépendantes en annexe.

Plus précisément, on propose selon l'invention un afficheur tête haute comprenant un dispositif de projection d'images adapté à transmettre en direction d'une lame semi-transparente les images générées par un écran comprenant une matrice de modules formant chacun un pixel, et une matrice d'éléments de commande destinés à adresser respectivement chacun de ces modules, dans lequel chaque module comprend au moins trois sous-modules émetteurs de lumière comportant chacun une structure électroluminescente tridimensionnelle, et dans lequel chaque élément de commande est destiné à adresser individuellement chaque sous-module. Au moins une structure électroluminescente tridimensionnelle comprend plusieurs microstructures électroluminescentes tridimensionnelles.

Ainsi, avantageusement, grâce aux structures électroluminescentes tridimensionnelles, l'écran de l'afficheur tête haute selon l'invention peut être de petites dimensions tout en offrant une luminosité suffisante pour chaque sous pixel, et donc pour chaque pixel.

L'efficacité lumineuse de l'écran est améliorée car il est lui-même source de lumière. Autrement dit, grâce à l'invention, l'écran n'est plus transmetteur de lumière mais émetteur de lumière.

En outre, l'efficacité lumineuse des pixels de l'écran est améliorée, grâce à l'aspect tridimensionnel des structures électroluminescentes.

En outre, l'encombrement spatial d'un tel écran est fortement réduit car il ne nécessite pas de dispositif de rétroéclairage.

D'autres caractéristiques non limitatives et avantageuses de l'écran de l'afficheur tête haute conforme à l'invention sont les suivantes :
- au sein de chaque module, au moins un premier sous-module est adapté à émettre de la lumière dans l'intervalle du spectre visible s'étendant entre 380 nm et 500 nm, au moins un deuxième sous-module est adapté à émettre de la lumière dans l'intervalle du spectre visible s'étendant entre 500 nm et 580 nm, et au moins un troisième sous-module est adapté à émettre de la lumière dans l'intervalle du spectre visible s'étendant entre 610 nm et 700 nm ;
- au moins 40% des modules comprennent un sous-module supplémentaire adapté à émettre de la lumière blanche dans l'intervalle du spectre visible s'étendant entre 380 nm et 700 nm ;
- chaque structure électroluminescente tridimensionnelle comprend au moins cent microstructures électroluminescentes tridimensionnelles ;
- chaque microstructure électroluminescente tridimensionnelle comprend une jonction émettrice cylindrique ;
- chaque structure électroluminescente tridimensionnelle est recouverte d'une couche cristallographique active adaptée à émettre de la lumière ;
- la structure électroluminescente tridimensionnelle de certains sous-modules est recouverte d'une couche de luminophores;
- les luminophores sont des phosphores ;
- chaque élément de commande de ladite matrice d'éléments de commande comprend au moins un transistor ; et
- chaque structure électroluminescente tridimensionnelle est à base de semi-conducteurs et comprend un substrat relativement plan à partir duquel s'élèvent des fils.

L'invention propose donc un afficheur tête haute comprenant un écran tel que décrit précédemment (formant ainsi un dispositif de génération d'images), et un dispositif de projection d'images adapté à transmettre en direction d'une lame semi-transparente les images générées par ledit écran.

Cette lame semi-transparente est par exemple un combineur (par exemple situé entre un pare-brise du véhicule et le conducteur), ou, en variante, le pare-brise du véhicule.

Le dispositif de projection d'images peut comprendre en pratique un miroir (miroir de repliement) agencé de manière à réfléchir en direction de la lame semi-transparente les images générées par l'écran.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une représentation schématique de principe d'un afficheur tête haute selon l'invention en position dans un véhicule ;
- la figure 2 est une représentation schématique d'un écran actif compris dans un afficheur tête haute selon l'invention, en vue avant ;
- la figure 3 est une représentation schématique d'une variante de réalisation d'un module compris dans l'écran actif de la figure 2 ;
- la figure 4 est une représentation schématique de profil de l'écran actif de la figure 2 ; et
- la figure 5 est une représentation schématique d'une microstructure électroluminescente tridimensionnelle comprise dans l'écran actif de la figure 4.

Dans la suite de la description, on désignera par « avant » le côté de l'écran qui est tourné vers le dispositif de projection, en position dans l'afficheur tête haute. Autrement dit « l'avant » est le côté de l'écran émettant de la lumière.

On désignera par « arrière », le côté de l'écran opposé au côté avant.

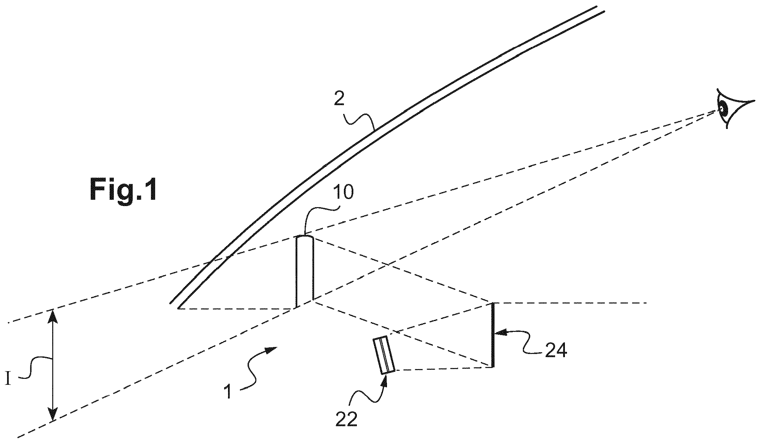

Sur la figure 1, on a représenté les éléments principaux d'un afficheur 1 tête haute destiné à équiper un véhicule, par exemple un véhicule automobile.

Un tel afficheur 1 est adapté à créer une image virtuelle I dans le champ de vision d'un conducteur du véhicule, de sorte que le conducteur puisse voir cette image virtuelle I et les informations éventuelles qu'elle contient sans avoir à détourner le regard.

A cet effet, l'afficheur 1 comprend un dispositif de génération 22 d'images adapté à générer une image, et un dispositif de projection 24 d'images adapté à transmettre cette image en direction d'une lame semi-transparente 10 placé dans le champ de vision du conducteur (voir figure 1).

Plus précisément, dans l'exemple de réalisation de l'afficheur tête haute 1, la lame semi-transparente 10 est un combineur 10 (c'est-à-dire une lame semi-transparente dédiée à l'afficheur tête haute).

Un tel combineur 10 est ici placé entre le parebrise 2 du véhicule et les yeux du conducteur.

En variante, la lame semi-transparente pourrait être confondue avec le parebrise 2 du véhicule. Autrement dit, dans cette variante, c'est le parebrise 2 du véhicule qui a la fonction de lame-semi transparente pour l'afficheur tête haute.

Par ailleurs, ici, le dispositif de projection 24 d'images comprend un miroir de repliement agencé de manière à réfléchir les images générées par le dispositif de génération 22 d'images en direction de la lame semi-transparente 10. Ici, ledit miroir de repliement est un miroir plan.

En variante, le dispositif de projection d'images pourrait comprendre une pluralité de miroirs et/ou d'autres éléments optiques tels qu'une lentille par exemple.

Le dispositif de génération 22 d'images est formé par un écran 220 actif, c'est-à-dire émetteur de lumière.

Avantageusement, cet écran 220 ne nécessite pas de rétroéclairage. Ainsi, le dispositif de génération 22 d'images décrit ici ne comprend pas de système permettant d'éclairer l'écran 220 par l'arrière, comme c'est le cas pour des écrans passifs.

L'écran 220 comprend, à l'avant, une matrice de modules 222 formant chacun un pixel dudit écran, et, à l'arrière, une matrice 260 d'éléments de commande destinés à adresser respectivement chacun de ces modules 222.

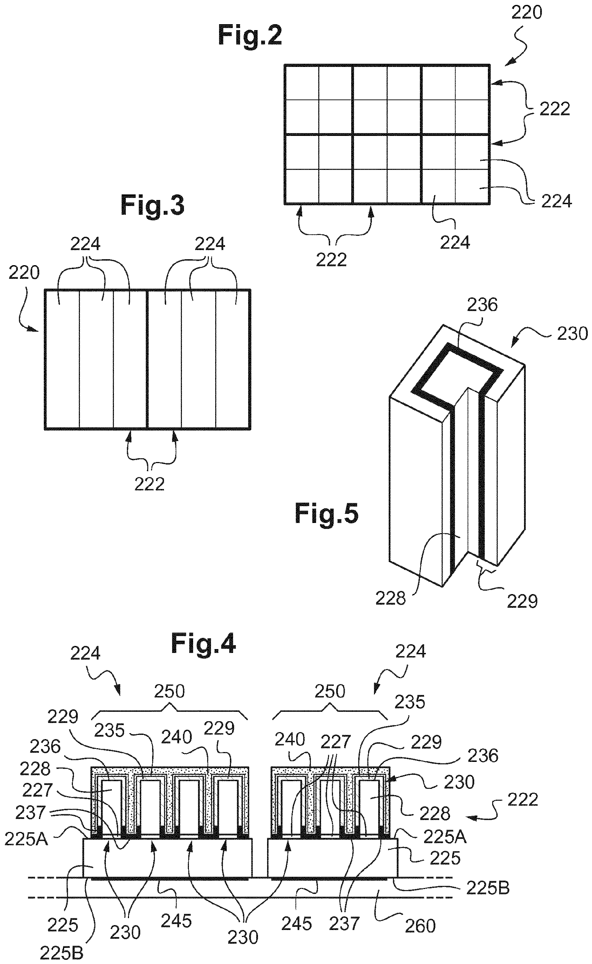

Autrement dit, l'écran 220 est divisé en modules 222, chaque module 222 formant un pixel dudit écran 220 (figure 2).

Chaque module 222 dudit écran 220 est lui-même subdivisé en au moins trois sous-modules 224 qui forment des sous-pixels de l'écran 220.

Ici, chaque module 222 peut comprendre trois (figure 3) ou quatre (figure 2) sous-modules 224.

En variante, chaque module pourrait comprendre plus de quatre sous-modules.

Les sous-modules 224 peuvent se présenter sous différentes formes.

Ils peuvent notamment être de de forme rectangulaire, en vue avant de l'écran 220, de sorte que assemblés trois par trois (figure 3), ou quatre par quatre, ils forment un module 222 de forme carrée.

Ici, vu par l'avant de l'écran 220, chaque sous-module 224 mesure environ 28,4 µm par 85,2 µm. Chaque sous-module 224 présente alors, dans le plan avant de l'écran, une surface de l'ordre de 2420 µm².

Ainsi, chaque module 222 comprenant trois de ces sous-modules 224 rectangulaires, présente, dans le plan de l'écran, une surface de l'ordre de 7260 µm².

En variante, on pourrait envisager que les sous-modules se présentent sous forme de carré (figure 2) en vue avant de l'écran de sorte que, assemblés quatre par quatre, ils forment un module 222 également de forme carrée.

Chaque sous-module 224 est émetteur de lumière et comporte à cet effet une structure électroluminescente tridimensionnelle 250.

En pratique, chaque structure électroluminescente tridimensionnelle 250 est adaptée à convertir un signal électrique en un rayonnement lumineux.

Pour ce faire, comme le montre la figure 4, chaque structure électroluminescente tridimensionnelle 250 comprend :
- un substrat 225 semi-conducteur dont une face avant 225A est plane,
- des socles de germination 227 disposés sur cette face avant 225A,
- des fils 228, chaque fil 228 étant en contact avec un socle de germination 227,
- des coques 229 comprenant un empilement de couches semiconductrices recouvrant au moins en partie chaque fil 228,
- une couche formant une électrode 235 recouvrant chaque coque 229 et s'étendant sur la face avant 225A du substrat mais séparé de lui par une couche isolante 237, et
- une pastille conductrice 245 disposée sur une face arrière 225B du substrat 225 à l'aplomb des fils 228.

Le substrat 225 semi-conducteur est généralement en silicium monocristallin, mais peut-être réalisé en d'autres matériaux semi-conducteurs tels que le germanium ou le carbure de silicium par exemple.

Le substrat 225 semi-conducteur de chaque structure électroluminescente tridimensionnelle 250 s'étend globalement dans le plan formant ledit écran 220.

Il mesure environ 28,4 µm par 85,2 µm, vu par l'avant de l'écran 220, Son épaisseur est ici inférieure à 1500 µm.

Ce substrat 225 peut être dopé (p ou n en fonction des besoins) de manière à abaisser sa résistivité électrique pour qu'elle atteigne celle des métaux (quelques mohm.cm).

Les socles de germination 227 sont réalisés en un matériau favorisant la croissance des fils 228.

Les socles de germination 227 peuvent être dopés du même type de conductivité (p ou n) que le substrat 225.

En outre, il peut éventuellement être prévu un traitement adapté à protéger les flancs des socles de germination 227 et les parties du substrat 225 non recouvertes par les socles de germination 227 de manière à empêcher la croissance des fils 228 sur ces surfaces traitées. Ce traitement peut consister en la création de régions diélectriques par exemple.

Les fils 228 s'étendent principalement selon une direction d'extension globalement perpendiculaire au plan du substrat 225.

Ils ont une forme globalement cylindrique et présentent une section droite dans le plan du substrat 225 pouvant avoir différentes formes, par exemple hexagonale, carrée, ou plus généralement polygonale.

Les axes d'extensions de deux fils adjacents sont distants de 0,5 µm à 10 µm. Ils peuvent par exemple être répartis régulièrement selon un réseau hexagonal.

Ils sont au moins en partie formés par au moins un matériau semi-conducteur tel que du silicium, du germanium, du carbure de silicium, ou une combinaison de ces composés.

Comme le substrat 225 et les socles de germination 227, ils peuvent également être dopés (p ou n).

Les coques 229 comprennent quant à elles différentes couches de matériau, dont une couche active recouvrant directement chaque fil 228.

La couche active est une couche cristallographique munie de puits quantiques et susceptible d'émettre de la lumière lorsqu'elle est stimulée. C'est à partir de cette couche active que la majorité de la lumière est émise par la structure électroluminescente tridimensionnelle 250.

De façon avantageuse, la couche active de chaque coque 229 forme une enveloppe individuelle autour de chaque fil 228, c'est-à-dire que la couche active de chaque coque 229 est fermée sur elle-même.

Il ressort de ce qui précède qu'au moins une structure électroluminescente tridimensionnelle 250 comporte en pratique plusieurs microstructures 230 électroluminescentes tridimensionnelles comprenant chacune un élément semi-conducteur filaire (voir figure 4).

Plus précisément, chaque microstructure 230 comprend un socle de germination 227, un fil 228 et une coque 229. De telles microstructures 230 sont connues et leur méthode d'obtention est décrite plus en détails dans le document FR 3 011 388 A1 par exemple.

Ici, chaque structure électroluminescente tridimensionnelle 250 comporte plusieurs de ces microstructures 230, voire plusieurs centaines de ces microstructures 230.

Les microstructures 230 de chaque structure électroluminescente tridimensionnelle 250 sont ici connectées en parallèle les unes aux autres. En outre, en pratique, les microstructures 230 d'une même structure électroluminescente tridimensionnelle 250 sont séparées les unes des autres par la couche isolante 237.

Le diamètre moyen de chaque microstructure 230 est par exemple inférieur à 2,5 µm, de sorte que pour atteindre la dimension souhaitée pour chaque sous-module 224, chaque structure électroluminescente tridimensionnelle 250 comporte par exemple entre cent et mille microstructures 230. Par « diamètre moyen », on entend le diamètre associé au disque ayant la même surface que la section droite de la microstructure 230 considérée.

Avantageusement, grâce aux structures électroluminescentes tridimensionnelles 250, l'écran 220 de l'afficheur tête haute selon l'invention peut être de petites dimensions tout en offrant une luminosité suffisante pour chaque sous pixel, et donc pour chaque pixel.

La hauteur de chaque microstructure 230, c'est-à-dire la dimension de la microstructure 230 selon la direction d'extension de son fil 228 est choisie au moins égale au diamètre moyen de la microstructure 230, mais de préférence au moins 10 fois supérieure audit diamètre moyen.

Le substrat 225 et les microstructures 230 formant des excroissances en face avant dudit substrat 225, constituent la structure tridimensionnelle de chaque structure électroluminescente tridimensionnelle 250. Cette structure tridimensionnelle est très différente des structures électroluminescentes bidimensionnelles usuelles constituées par un empilement de couches de matériaux.

De façon avantageuse, chaque microstructure 230 comprend un matériau semi-conducteur et des puits quantiques, et chaque microstructure 230 est par conséquent capable de convertir un signal électrique en un rayonnement lumineux. Ainsi, la surface totale à partir de laquelle peut être émis le rayonnement lumineux correspond à la surface cumulée de l'ensemble des microstructures 230, à savoir la surface cumulée de chaque pourtour et de chaque section droite de chaque microstructure 230.

En effet, grâce à la construction décrite ci-dessus et comme schématiquement représenté en figure 5, chaque microstructure 230 comprend une jonction 236 (où sont formés les puits quantiques émetteurs de lumière) tridimensionnelle, ici de forme générale cylindrique avec un axe de cylindre s'étendant selon la direction générale d'extension des fils 228.

Ici, la jonction 236 est comprise dans la coque 229 de chaque microstructure 230. Ainsi, pour chaque microstructure 230, la jonction 236 émettrice de lumière s'étend à la fois sur toute la hauteur et sur toute la périphérie du fil 228, ce qui assure la grande efficacité déjà mentionnée.

Par ailleurs, l'électrode 235 recouvrant les microstructures 230 de chaque structure électroluminescente tridimensionnelle 250 est adaptée à polariser la couche active recouvrant chaque fil 228 et à laisser passer le rayonnement électromagnétique émis par les microstructures 230.

La pastille conductrice 245 est quant à elle adaptée faire passer un signal électrique à travers la structure électroluminescente tridimensionnelle 250 correspondante.

Enfin, chaque structure électroluminescente tridimensionnelle 250 de chaque sous-module 224 est recouverte d'une couche d'encapsulation 240 (voir figure 4).

Cette couche d'encapsulation 240 est réalisée en un matériau isolant et au moins partiellement transparent.

Elle est adaptée à protéger les microstructures 230 et l'électrode 235 comprises dans chaque structure électroluminescente tridimensionnelle 250.

De façon générale, au sein de chaque module 222, au moins un premier sous-module 224 est adapté à émettre de la lumière dans l'intervalle du spectre visible s'étendant entre 380 nm et 500 nm, c'est-à-dire dans le bleu, au moins un deuxième sous-module 224 est adapté à émettre de la lumière dans l'intervalle du spectre visible s'étendant entre 500 nm et 580 nm, c'est-à-dire dans le vert, et au moins un troisième sous-module 224 est adapté à émettre de la lumière dans l'intervalle du spectre visible s'étendant entre 610 nm et 700 nm, c'est-à-dire dans le rouge.

En pratique, ces premier, deuxième et troisième sous-modules 224 sont disposés successivement les uns à côtés des autres en vue avant de l'écran (voir figure 2).

Il est également possible d'ajouter à certains des modules 222 un sous-module 224 supplémentaire émettant dans tout le spectre visible, c'est-à-dire émettant une lumière blanche composée de rayonnements lumineux de longueurs d'onde s'étendant entre 380 nm et 700 nm environ.

Ainsi, deux modules 222 successifs sont soit deux modules 222 comprenant une succession de sous-modules 224 « Rouge-Vert-Bleu », soit deux modules 222 comprenant une succession de sous-modules 224 « Rouge-Vert-Bleu-Blanc », soit un module 222 comprenant une succession de sous-modules 224 « Rouge-Vert-Bleu » suivi d'un module 222 comprenant une succession de sous-modules 224 « Rouge-Vert-Bleu-Blanc ».

Pour que chaque sous-module 224 soit émetteur de lumière, on peut envisager, selon un premier mode de réalisation, que la structure électroluminescente tridimensionnelle 250 de chaque sous-module 224 soit adaptée à émettre elle-même un rayonnement lumineux, et, selon un deuxième mode de réalisation, que certaines structures électroluminescentes tridimensionnelles 250 soient en outre recouvertes d'une couche de luminophores qui émet un rayonnement lumineux.

Ainsi, quel que soit le mode de réalisation envisagé, à partir de trois sous-modules 224, chaque module 222 est capable d'émettre une multitude de couleurs différentes.

Avantageusement, le sous-module 224 supplémentaire émettant de la lumière blanche permet de moduler plus facilement l'intensité lumineuse émise par le pixel formé par le module 222 comprenant ce sous-module 224 supplémentaire.

En pratique, les premier, deuxième et troisième sous-modules 224 émettent chacun à une longueur d'onde précise.

Mais on pourrait également envisager que les premier, deuxième et troisième sous-modules émettent chacun dans un intervalle réduit de longueurs d'onde, c'est-à-dire sur une plage continue s'étendant sur quelques dizaines de nanomètres, par exemple sur 50 nm ou plus.

Selon le premier mode de réalisation, les couches actives des coques 229 des microstructures 230 formant chaque structure électroluminescente tridimensionnelle 250 des premier, deuxième et troisième sous-modules 224 sont conçues de manière à pouvoir émettre de la lumière dans l'intervalle du spectre visible utile.

Autrement dit, la couche active de la coque 229 des microstructures 230 de chaque structure électroluminescente tridimensionnelle 250 des premier, deuxième et troisième sous-modules 224 est une couche cristallographique adaptée à émettre de la lumière.

En particulier, la couche active de la coque 229 des microstructures 230 de la première structure électroluminescente tridimensionnelle 250 est adaptée à émettre dans le bleu, la couche active de la coque 229 des microstructures 230 de la deuxième structure électroluminescente tridimensionnelle 250 est adaptée à émettre dans le vert, la couche active de la coque 229 des microstructures 230 de la troisième structure électroluminescente tridimensionnelle 250 est adaptée à émettre dans le rouge.

Pour cela, il est possible d'adapter l'épaisseur ou les compositions des puits quantiques formant ces couches actives.

En d'autres termes, la structure cristallographique de la couche active de chaque coque 229 peut être adaptée pour que ladite couche active émette à une longueur d'onde choisie.

Selon le deuxième mode de réalisation, toutes les couches actives des coques 229 des microstructures 230 formant chaque structure électroluminescente tridimensionnelle 250 des premier, deuxième et troisième sous-modules 224 sont conçues de manière à pouvoir émettre de la lumière monochromatique, ici dans le bleu.

Selon ce deuxième mode de réalisation, la structure électroluminescente tridimensionnelle 250 de certains sous-modules 224 est recouverte d'une couche de luminophores de manière à émettre de la lumière dans le rouge ou dans le vert.

Ici, la couche de luminophores est confondue avec la couche d'encapsulation 240.

En variante, la couche de luminophores pourrait être placée par-dessus la couche d'encapsulation.

En particulier, les luminophores peuvent être des premiers phosphores adaptés à émettre de la lumière verte en étant stimulés par au moins une longueur d'onde de l'intervalle du spectre visible s'étendant entre 380 nm et 500 nm (bleu), et des deuxièmes phosphores adaptés à émettre de la lumière rouge en étant stimulés par au moins une longueur d'onde de l'intervalle du spectre visible s'étendant entre 380 nm et 500 nm (bleu).

Il est alors possible de recouvrir la structure électroluminescente tridimensionnelle du deuxième sous-module 224 avec une couche de premiers phosphores de sorte qu'il émette de la lumière verte, et de recouvrir la structure électroluminescente tridimensionnelle du troisième sous-module 224 avec une couche de deuxièmes phosphores de sorte qu'il émette de la lumière rouge.

De façon avantageuse, les phosphores couvrent la majeure partie de la surface des deuxième et troisième sous-modules 224. Par exemple, les phosphores couvrent plus de 80% de la surface totale des sous-modules 224 auxquels ils appartiennent.

Ainsi, l'utilisation de luminophores pour obtenir un rayonnement lumineux de couleur voulue permet d'obtenir une lumière homogène sur toute la surface du sous-module 224 considéré.

Par ailleurs, ici, au moins 40% des modules 222 comprennent un sous-module supplémentaire adapté à émettre de la lumière blanche.

En pratique, un tel sous-module supplémentaire comprend par exemple trois structures électroluminescentes tridimensionnelles: une première capable d'émettre un rayonnement lumineux dans le bleu, une deuxième capable d'émettre dans le vert, et une troisième capable d'émettre dans le rouge, ces trois structures électroluminescentes tridimensionnelles étant connectées en série les unes avec les autres. Ainsi, le sous-module supplémentaire est susceptible d'émettre simultanément une lumière bleue, une lumière verte et une lumière rouge, ce qui est équivalent à l'émission d'une lumière blanche. Un tel sous-module supplémentaire est plus particulièrement décrit dans le document FR 3 011 388 A1.

En variante, on pourrait envisager que le sous-module supplémentaire comprenne une seule structure électroluminescente tridimensionnelle capable d'émettre de la lumière bleue, recouverte d'une couche de différents luminophores adaptés à émettre respectivement de la lumière rouge et de la lumière verte lorsqu'ils sont stimulés par une longueur d'onde du spectre visible s'étendant entre 380 nm et 500 nm (bleu). Ainsi, ce sous-module supplémentaire émettrait des rayonnements lumineux dans le vert et dans le rouge, et quelques rayonnements lumineux dans le bleu (ceux n'ayant pas rencontrés de luminophores en traversant la couche de luminophores). Le rayonnement lumineux global émis par ce sous-module supplémentaire serait perçu comme de la lumière blanche.

En variante encore, on pourrait envisager que le sous-module supplémentaire comprenne une seule structure électroluminescente tridimensionnelle capable d'émettre de la lumière bleue, recouverte d'une couche de luminophores capables d'émettre de la lumière dans l'intervalle du spectre visible s'étendant entre 580 nm et 600 nm, c'est-à-dire dans le jaune, lorsqu'ils sont stimulés par une longueur d'onde du spectre visible s'étendant entre 380 nm et 500 nm (bleu). Ainsi, ce sous-module supplémentaire émettrait des rayonnements lumineux dans le jaune et quelques rayonnements lumineux dans le bleu, ce qui est équivalent à une émission de la lumière blanche.

Il serait également envisageable que les sous-modules émettent dans des intervalles de longueurs d'onde autres que ceux associés aux couleurs bleue, verte, rouge ou blanche.

Par ailleurs, avantageusement, les microstructures 230 électroluminescentes tridimensionnelles émettent de la lumière dans toutes les directions.

De manière à profiter au maximum des émissions de lumière, la face avant 225A du substrat 225 située entre les microstructures 230 est ici recouverte d'un miroir (non représenté) qui réfléchit les rayons lumineux vers l'avant.

Les sous-modules 224 décrits ici sont des sous-modules individuels agencés les uns à côté des autres de manière à former chaque module 222, et par suite la matrice de modules 222 de l'écran 220.

Chaque sous-module 224 est adressé individuellement, par l'arrière, grâce à un élément de commande.

Ici, chaque élément de commande comprend au moins un transistor.

Plus précisément, ici, chaque élément de commande comprend trois, voire quatre, transistors, chaque transistor étant relié électroniquement à un sous-module 224 via la pastille conductrice 245 associée à ce sous-module 224.

La matrice de modules 222 formée par assemblage des sous-modules 224 est rapportée sur la matrice 260 d'éléments de commande de sorte que chaque transistor commande la tension appliquée à et/ou le courant injecté dans une structure électroluminescente tridimensionnelle 250 correspondante.

En variante, on pourrait envisager que la matrice d'éléments de commande soit intégrée dans le substrat compris dans la matrice de modules.

Ainsi, de façon analogue à ce qui existe dans les écrans à transistors en couche mince (dits *TFT* pour *"Thin-Film Transistor"*)*,* les modules 222 et sous-modules 224 de l'écran 220 sont adressés individuellement par des éléments de commande également agencés sous forme de matrice 260.

L'écran 220 actif ainsi formé présente un facteur de forme libre. En effet, l'écran 220 peut adopter n'importe quelle forme choisie, il suffit pour cela d'agencer convenablement les sous-modules 224 et/ou les modules 222.

Ceci est particulièrement avantageux dans le cas des écrans pour afficheur tête haute puisqu'il existe une distorsion des images intrinsèque au fonctionnement desdits afficheurs tête haute qui peut être compensée grâce à la forme des écrans générateurs d'images.

De plus, de manière avantageuse, grâce aux structures électroluminescentes tridimensionnelles 250, l'écran 220 est de petites dimensions, tout en offrant une luminosité satisfaisante pour chaque pixel.

En outre, avantageusement, l'utilisation des structures électroluminescentes tridimensionnelles 250 réduit l'échauffement généré par le dispositif de génération d'images. Il n'est alors pas nécessaire d'utiliser de radiateur à dissipation thermique et l'encombrement de l'afficheur tête haute selon l'invention est ainsi réduit.

Avantageusement, l'écran actif ainsi formé ne nécessitant pas de rétroéclairage, le rendement optique de l'afficheur tête haute selon la présente invention est nettement amélioré, et son encombrement est encore réduit.

Par ailleurs, l'invention permet de réaliser un gain économique notable, les structures électroluminescentes tridimensionnelles utilisées étant peu coûteuses et nécessitant peu d'énergie pour émettre de la lumière.

## Revendications

1. Afficheur (1) tête haute comprenant un dispositif de projection (24) d'images adapté à transmettre en direction d'une lame semi-transparente (10) les images générées par un écran (22, 220) comprenant une matrice de modules (222) formant chacun un pixel, et une matrice (260) d'éléments de commande destinés à adresser respectivement chacun de ces modules (222), chaque module (222) comprenant au moins trois sous-modules (224) émetteurs de lumière comportant chacun une structure électroluminescente tridimensionnelle (250), chaque élément de commande étant destiné à adresser individuellement chaque sous-module (224), **caractérisé en ce qu'**au moins une structure électroluminescente tridimensionnelle (250) comprend plusieurs microstructures (230) électroluminescentes tridimensionnelles.

2. Afficheur (1) tête haute selon la revendication 1, dans lequel, au sein de chaque module (222), au moins un premier sous-module (224) est adapté à émettre de la lumière dans l'intervalle du spectre visible s'étendant entre 380 nm et 500 nm, au moins un deuxième sous-module (224) est adapté à émettre de la lumière dans l'intervalle du spectre visible s'étendant entre 500 nm et 580 nm, et au moins un troisième sous-module (224) est adapté à émettre de la lumière dans l'intervalle du spectre visible s'étendant entre 610 nm et 700 nm.

3. Afficheur (1) tête haute selon l'une des revendications 1 et 2, dans lequel au moins 40% des modules (222) comprennent un sous-module supplémentaire adapté à émettre de la lumière blanche dans l'intervalle du spectre visible s'étendant entre 380 nm et 700 nm.

4. Afficheur (1) tête haute selon l'une des revendications 1 à 3, dans lequel chaque structure électroluminescente tridimensionnelle (250) comprend au moins cent microstructures (230) électroluminescentes tridimensionnelles.

5. Afficheur (1) tête haute selon l'une des revendications 1 à 4, dans lequel chaque microstructure (230) électroluminescente tridimensionnelle comprend une jonction (236) émettrice cylindrique.

6. Afficheur (1) tête haute selon l'une des revendications 1 à 5, dans lequel chaque structure électroluminescente tridimensionnelle (250) est recouverte d'une couche cristallographique active adaptée à émettre de la lumière.

7. Afficheur (1) tête haute selon l'une des revendications 1 à 6, dans lequel la structure électroluminescente tridimensionnelle (250) de certains sous-modules (224) est recouverte d'une couche de luminophores.

8. Afficheur (1) tête haute selon la revendication 7, selon lequel les luminophores sont des phosphores.

9. Afficheur (1) tête haute selon l'une des revendications 1 à 8, selon lequel chaque élément de commande de ladite matrice (260) d'éléments de commande comprend au moins un transistor.

10. Afficheur (1) tête haute selon l'une des revendications 1 à 9, selon lequel chaque structure électroluminescente tridimensionnelle (250) est à base de semi-conducteurs et comprend un substrat (225) plan à partir duquel s'élèvent des fils (228).

11. Afficheur (1) tête haute selon l'une des revendications précédentes, dans lequel la lame semi-transparente est un combineur (10).

12. Afficheur tête haute selon l'une des revendications 1 à 10, dans lequel la lame semi-transparente est un pare-brise.

13. Afficheur tête haute selon l'une des revendications précédentes, dans lequel le dispositif (24) de projection d'images comprend un miroir agencé de manière à réfléchir en direction de la lame semi-transparente (10) les images générées par l'écran (22, 220).

## Patentansprüche

1. Head-up-Display (1), umfassend eine Bildprojektionsvorrichtung (24), die geeignet ist, in Richtung einer halbtransparenten Scheibe (10) die Bilder zu übertragen, die von einem Bildschirm (22, 220) erzeugt werden, der eine Matrix aus Modulen (222) umfasst, die jeweils ein Pixel bilden, und eine Matrix (260) aus Steuerelementen, die dazu bestimmt sind, jeweils jedes dieser Module (222) zu adressieren, wobei jedes Modul (222) mindestens drei Licht emittierende Submodule (224) umfasst, von denen jedes eine dreidimensionale elektrolumineszente Struktur (250) aufweist, wobei jedes Steuerelement dazu bestimmt ist, jedes Submodul (224) individuell zu adressieren, **dadurch gekennzeichnet, dass** mindestens eine dreidimensionale elektrolumineszente Struktur (250) mehrere dreidimensionale elektrolumineszente Mikrostrukturen (230) umfasst.

2. Head-up-Display (1) nach Anspruch 1, bei dem, innerhalb jedes Moduls (222), mindestens ein erstes Submodul (224) geeignet ist, Licht in dem Intervall des sichtbaren Spektrums zu emittieren, das sich zwischen 380 nm und 500 nm erstreckt, mindestens ein zweites Submodul (224) geeignet ist, Licht in dem Intervall des sichtbaren Spektrums zu emittieren, das sich zwischen 500 nm und 580 nm erstreckt, und mindestens ein drittes Submodul (224) geeignet ist, Licht in dem Intervall des sichtbaren Spektrums zu emittieren, das sich zwischen 610 nm und 700 nm erstreckt.

3. Head-up-Display (1) nach einem der Ansprüche 1 und 2, bei dem mindestens 40 % der Module (222) ein zusätzliches Submodul umfassen, das geeignet ist, weißes Licht in dem Intervall des sichtbaren Spektrums zu emittieren, das sich zwischen 380 nm und 700 nm erstreckt.

4. Head-up-Display (1) nach einem der Ansprüche 1 bis 3, bei dem jede dreidimensionale elektrolumineszente Struktur (250) mindestens einhundert dreidimensionale elektrolumineszente Mikrostrukturen (230) umfasst.

5. Head-up-Display (1) nach einem der Ansprüche 1 bis 4, bei dem jede dreidimensionale elektrolumineszente Mikrostruktur (230) einen zylindrischen emittierenden Übergang (236) umfasst.

6. Head-up-Display (1) nach einem der Ansprüche 1 bis 5, bei dem jede dreidimensionale elektrolumineszente Struktur (250) mit einer aktiven kristallografischen Schicht überzogen ist, die geeignet ist, Licht zu emittieren.

7. Head-up-Display (1) nach einem der Ansprüche 1 bis 6, bei dem die dreidimensionale elektrolumineszente Struktur (250) von einigen Submodulen (224) mit einer Schicht aus Luminophoren überzogen ist.

8. Head-up-Display (1) nach Anspruch 7, bei dem die Luminophore Phosphore sind.

9. Head-up-Display (1) nach einem der Ansprüche 1 bis 8, bei dem jedes Steuerelement der Matrix (260) aus Steuerelementen mindestens einen Transistor umfasst.

10. Head-up-Display (1) nach einem der Ansprüche 1 bis 9, bei dem jede dreidimensionale elektrolumineszente Struktur (250) auf Halbleiterbasis ist und ein ebenes Substrat (225) umfasst, von dem aus sich Drähte (228) erheben.

11. Head-up-Display (1) nach einem der vorhergehenden Ansprüche, bei dem die halbtransparente Scheibe ein Combiner (10) ist.

12. Head-up-Display nach einem der Ansprüche 1 bis 10, bei dem die halbtransparente Scheibe eine Windschutzscheibe ist.

13. Head-up-Display nach einem der vorhergehenden Ansprüche, bei dem die Bildprojektionsvorrichtung (24) einen Spiegel umfasst, der so angeordnet ist, dass er in Richtung der halbtransparenten Scheibe (10) die von dem Bildschirm (22, 220) erzeugten Bilder reflektiert.

## Claims

1. Head-up display (1) comprising an image-projecting device (24) configured to transmit, in the direction of a semi-transparent plate (10), the images generated by a screen (22, 220) comprising a matrix array of modules (222) that each form one pixel, and a matrix array (260) of control elements that are intended to address each of these modules (222), respectively, each module (222) comprising at least three light-emitting submodules (224) each comprising a three-dimensional electroluminescent structure (250), each control element being intended to individually address each submodule (224), **characterized in that** at least one three-dimensional electroluminescent structure (250) comprises a plurality of three-dimensional electroluminescent microstructures (230).

2. Head-up display (1) according to Claim 1, wherein, within each module (222), at least one first submodule (224) is suitable for emitting light in the interval of the visible spectrum extending between 380 nm and 500 nm, at least one second submodule (224) is suitable for emitting light in the interval of the visible spectrum extending between 500 nm and 580 nm, and at least one third submodule (224) is suitable for emitting light in the interval of the visible spectrum extending between 610 nm and 700 nm.

3. Head-up display (1) according to one of Claims 1 and 2, wherein at least 40% of the modules (222) comprise an additional submodule suitable for emitting white light in the interval of the visible spectrum extending between 380 nm and 700 nm.

4. Head-up display (1) according to one of Claims 1 to 3, wherein each three-dimensional electroluminescent structure (250) comprises at least one-hundred three-dimensional electroluminescent microstructures (230).

5. Head-up display (1) according to one of Claims 1 to 4, wherein each three-dimensional electroluminescent microstructure (230) comprises a cylindrical emitting junction (236).

6. Head-up display (1) according to one of Claims 1 to 5, wherein each three-dimensional electroluminescent structure (250) is covered with an active crystallographic layer suitable for emitting light.

7. Head-up display (1) according to one of Claims 1 to 6, wherein the three-dimensional electroluminescent structure (250) of certain submodules (224) is covered with a layer of luminophores.

8. Head-up display (1) according to Claim 7, wherein the luminophores are phosphors.

9. Head-up display (1) according to one of Claims 1 to 8, wherein each control element of said matrix array (260) of control elements comprises at least one transistor.

10. Head-up display (1) according to one of Claims 1 to 9, wherein each three-dimensional electroluminescent structure (250) is based on semiconductors and comprises a planar substrate (225) from which wires (228) rise.

11. Head-up display (1) according to one of the preceding claims, wherein the semi-transparent plate is a combiner (10).

12. Head-up display according to one of Claims 1 to 10, wherein the semi-transparent plate is a windscreen.

13. Head-up display according to one of the preceding claims, wherein the image-projecting device (24) comprises a mirror that is arranged so as to reflect, in the direction of the semi-transparent plate (10), the images generated by the screen (22, 220).
